Europäisches Patentamt

European Patent Office

Office européen des brevets

(11) Veröffentlichungsnummer: **0 276 034**
**A2**

## (12) EUROPÄISCHE PATENTANMELDUNG

(21) Anmeldenummer: **88200036.7**

(51) Int. Cl.⁴: **G 01 N 24/08**

(22) Anmeldetag: **13.01.88**

(30) Priorität: **23.01.87 DE 3701849**

(43) Veröffentlichungstag der Anmeldung:
**27.07.88 Patentblatt 88/30**

(84) Benannte Vertragsstaaten: **DE FR GB**

(71) Anmelder: **Philips Patentverwaltung GmbH**
**Wendenstrasse 35 Postfach 10 51 49**
**D-2000 Hamburg 1 (DE)**

(84) Benannte Vertragsstaaten: **DE**

(71) Anmelder: **N.V. Philips' Gloeilampenfabrieken**
**Groenewoudseweg 1**
**NL-5621 BA Eindhoven (NL)**

(84) Benannte Vertragsstaaten: **FR GB**

(72) Erfinder: **Kuhn, Michael, Dr.**
**Sintelstrasse 77**
**D-2000 Hamburg 61 (DE)**

(74) Vertreter: **Hartmann, Heinrich, Dipl.-Ing. et ai**
**Philips Patentverwaltung GmbH Wendenstrasse 35**
**Postfach 10 51 49**
**D-2000 Hamburg 1 (DE)**

(54) **Verfahren für die Kernspintomographie.**

(57) 2.1. Bei dem bekannten Verfahren zur Bestimmung der Längs-und gegebenenfalls der Querrelaxationszeit sind relativ lange Repetitionszeiten erforderlich, was relativ lange Meßzeiten ergibt.

2.2. Bei der Erfindung umfaßt jede Sequenz mindestens zwei Teilsequenzen, von denen jede wenigstens einen Hochfrequenzimpuls enthält, wobei die Repetitionszeiten voneinander abweichen und so kurz sind, daß die Längsmagnetisierung bei Beginn der nächsten Teilsequenz noch nicht ihren ursprünglichen Wert erreicht hat.

2.3. Die Erfindung gestattet die Erzeugung von T1- und gegebenenfalls von T2-gewichteten Tomogrammen, insbesondere in der medizinischen Kernspin-Diagnostik.

FIG.3

EP 0 276 034 A2

## Beschreibung

"Verfahren für die Kernspintomographie"

Die Erfindung betrifft ein Verfahren für die Kernspintomographie, wobei in Anwesenheit eines homogenen stationären Magnetfeldes eine Vielzahl von Sequenzen auf einen Untersuchungsbereich einwirkt, die die Erzeugung eines Hochfrequenzimpulses zum Kippen der Kernmagnetisierung um einen Winkel, der kleiner ist als 90°, das Einschalten von magnetischen Gradientenfeldern mit nach Größe oder Richtung von Sequenz zu Sequenz veränderbarem Gradienten und die Erfassung von Kernspin-Resonanzsignalen während oder nach der Einwirkung der magnetischen Gradientenfelder einschließen.

Ein solches Verfahren ist aus der Zeitschrift "Magnetic Resonance Imaging", Vol. 3, pp 297-299, 1985 bekannt. Die einzelnen Sequenzen haben dabei derart kurze Repetitionszeiten (das ist der zeitliche Abstand zwischen dem jeweils ersten Impuls zweier aufeinanderfolgender Sequenzen), daß die Längsmagnetisierung im Anschluß an eine Sequenz ihren ursprünglichen Zustand noch nicht erreicht hat, wenn die nächste Sequenz beginnt. Deshalb werden der eigentlichen Kernspinuntersuchung eine Reihe von Sequenzen vorangestellt, deren Echosignale nicht ausgewertet werden. Nach einigen solcher Sequenzen hat die Längsmagnetisierung zu Beginn einer Sequenz einen stationären Zustand erreicht und die von da an auftretenden Echosignale können zur Erzeugung eines Tomogramms, das die räumliche Verteilung der Kernmagnetisierung im Untersuchungsbereich darstellt, herangezogen werden. Der Flipwinkel, d.h. der Winkel, um den die Kernmagnetisierung aus der Längsrichtung gekippt wird, muß dabei kleiner als 90° sein, wenn hinsichtlich des Signal/Rauschverhältnisses ein Optimum erreicht werden soll.

Aufgrund der kurzen Repetitionszeiten können bei dem bekannten Verfahren die zur Berechnung eines Tomogramms erforderlichen Echosignale in relativ kurzer Zeit gewonnen werden. Das auf diese Weise erzeugte Tomogramm beinhaltet jedoch relativ wenig Informationen über die sogenannte Längsrelaxationszeit T1. Die Kenntnis der räumlichen Verteilung dieser Relaxationszeit ist für die medizinische Diagnostik aber von wesentlicher Bedeutung.

Es sind verschiedene Verfahren bekannt, die die Berechnung der T1-Relaxationszeit gestatten (vgl. "Journ. Mag. Res." 65, Seiten 481-490). Diese Verfahren erfordern aber lange Repetitionszeiten in der Größenordnung von 2 sec, so daß die Meßzeit zur Erfassung der für ein hochauflösendes Tomogramm erforderlichen Echosignale bis zu zehn Minuten betragen kann.

Aufgabe der vorliegenden Erfindung ist es, ein Verfahren der eingangs genannten Art so auszugestalten, daß damit die Längsrelaxationszeit T1 bestimmt werden kann, und eine Anordnung zur Durchführung dieses Verfahrens anzugeben.

Bei der Erfindung setzt sich also eine Sequenz aus wenigstens zwei aufeinanderfolgenden Teilsequenzen zusammen, bei denen durch den zeitlichen Verlauf der magnetischen Gradientenfelder die räumliche Abhängigkeit von Frequenz und/oder Phase der Kernmagnetisierung jeweils die gleiche ist, die jeweils gleichartige Hochfrequenzimpulse aufweisen, jedoch unterschiedliche Repetitionszeiten.

Wenn die Repetitionszeit groß im Vergleich zur Längsrelaxationszeit des Gewebes im Untersuchungsbereich wäre oder wenn die Repetitionszeiten der Teilsequenzen gleich wären, hätte die Längsmagnetisierung beim Auftreten des Hochfrequenzimpulses einer Teilsequenz in einem Bildpunkt (das ist ein endlicher Bereich des Untersuchungsfeldes) jeweils den gleichen Wert - zumindest im stationären Zustand. Damit hätte auch die Quermagnetisierung nach einem Hochfrequenzimpuls, die für das Entstehen des Kernspin-Resonanzsignals ursächlich ist, den gleichen Wert - wenn jeweils gleichartige Hochfrequenzimpulse in den Teilsequenzen benutzt werden. Deshalb würden aus den Teilsequenzen erzeugte Tomogramme miteinander identisch sein.

Bei der Erfindung sind die Repetitionszeiten aber so kurz, daß die Längsmagnetisierung bei Beginn einer Teilsequenz ihren ursprünglichen Wert nicht erreicht hat, und außerdem weichen die Repetitionszeiten der Teilsequenzen voneinander ab. Dies bedeutet, daß auch im stationären Zustand zu Beginn einer Teilsequenz die Längsmagnetisierung unterschiedliche Werte hat. Infolgedessen weicht auch die Quermagnetisierung, die in einem Bildpunkt durch den Hochfrequenzimpuls einer Teilsequenz erzeugt wird, von der durch einen identischen Hochfrequenzimpuls einer bzw. der anderen Teilsequenz erzeugten Quermagnetisierung ab, d.h. daß sich die Tomogramme, die aus Teilsequenzen mit jeweils gleicher Repetitionszeit erzeugt werden, voneinander unterscheiden. Diese Unterschiede sind im wesentlichen vom zeitlichen Verlauf der Längsrelaxation bestimmt, und deshalb kann aus diesen Unterschieden, d.h. aus den Werten der Kernmagnetisierung die jeweils einem Bildpunkt in den verschiedenen Tomogrammen zugeordnet sind, die Längsrelaxationszeit, also die Zeitkonstante, mit der die Längsrelaxation abläuft, bestimmt werden.

Eine Anordnung zur Durchführung des Verfahrens nach Anspruch 1, die versehen ist mit Mitteln zum Erzeugen eines homogenen stationären Magnetfeldes, Mitteln zum Erzeugen von Hochfrequenzimpulsen, Mitteln zum Erzeugen wenigstens eines magnetischen Gradientenfeldes mit von Sequenz zu Sequenz veränderbarer Größe oder Richtung des Gradienten, einer Steuereinheit zum Steuern der Mittel zur Erzeugung der Hochfrequenzimpulse und Mittel zum Erzeugen des magnetischen Gradientenfeldes, Mitteln zum Erfassen von Kernspin-Resonanzsignalen und einer Recheneinheit zur Erzeugung von Tomogrammen aus den Kernspin-Resonanzsignalen, ist dadurch gekennzeichnet, daß die Steuereinheit so ausgebildet ist, daß jeweils zwei hinsichtlich der Repetitionszeit voneinander abweichende Teilsequenzen aufeinanderfolgen, und daß die Recheneinheit so programmiert ist, daß aus den Echosignalen von Teilsequenzen mit jeweils gleicher Repetitionszeit je ein Tomogramm berechnet wird, daß aus den in den Tomogrammen enthaltenen Werten der Kernmagnetisierung für jeweils einen Bildpunkt und aus der zugehörigen Repetitionszeit die Längsrelaxationszeit für den jeweiligen Bildpunkt bestimmt wird.

Eine Weiterbildung des erfindungsgemäßen Verfahrens sieht vor, daß wenigstens eine der Teilsequenzen zwei 180°-Impulse aufweist, daß aus den davon hervorgerufenen Spin-Echo-Signalen weitere Tomogramme berechnet werden, und daß aus den unterschiedlichen Werten der Kernmagnetisierung dieser Tomogramme und dem Abstand der Spin-Echo-Signale von dem ersten Hochfrequenzimpuls der Teilsequenz die Querrelaxationszeit bestimmt wird.

Wenn auf diese Weise für jeden Bildpunkt die Längs- bzw. die Querrelaxationszeit T1 bzw. T2 ermittelt worden ist, ist es möglich, synthetisch - also ohne den Patienten einer erneuten Untersuchung zu unterziehen - Tomogramme zu erstellen, die die Kernmagnetisierungsverteilung bei beliebig vorgebbaren Repetitionszeiten und Echozeiten (das ist der zeitliche Abstand zwischen einem Kernresonanzsignal und einem Hochfrequenzimpuls) zeigen.

Die Erfindung wird nachstehend anhand der Zeichnung näher erläutert. Es zeigen:

    Fig. 1 ein Kernspin-Tomographiegerät, mit dem das erfindungsgemäße Verfahren durchführbar ist,

    Fig. 2 ein Blockschaltbild eines solchen Gerätes,

    Fig. 3 den zeitlichen Verlauf einer Sequenz zur Bestimmung von T1 und der Längsmagnetisierung,

    Fig. 4 den zeitlichen Verlauf einer zur zusätzlichen Bestimmung von T2 modifizierten Teilsequenz, und

    Fig. 5 die Quermagnetisierung als Funktion von T2.

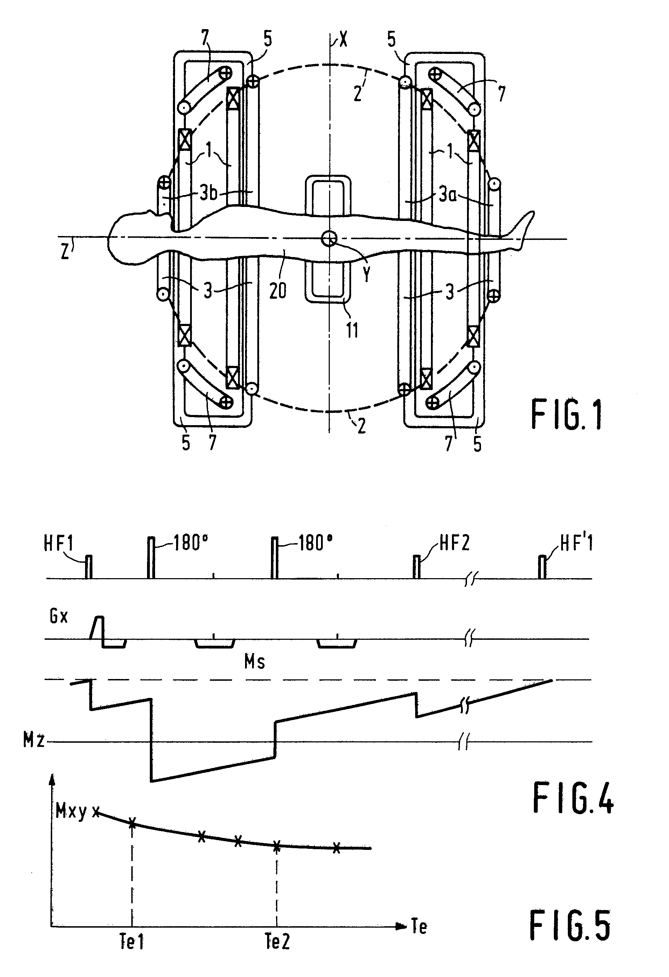

Das in Fig. 1 schematisch dargestellte Kernspin-Tomographiegerät enthält eine aus vier Spulen 1 bestehende Anordnung zur Erzeugung eines homogenen stationen Magnetfeldes, das z.B. 2 T beträgt. Dieses Feld verläuft in z-Richtung eines kartesischen xyz-Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5, die den gleichen Aufbau wie die Spulen 7 habe können, die jedoch diesen gegenüber um 90° versetzt angeordnet sind. Von diesen vier Spulen sind in Fig. 1 nur zwei dargestellt. Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des kartesischen Koordinatensystems bildet, nur durch das stationäre homogene Magnetfeld der Spulenanordnung 1 bestimmt.

Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes, verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. Im Anschluß an jeden Hochfrequenzimpuls dient die Hochfrequenzspule 11 zum Empfangen von im Untersuchungsbereich erzeugten Kernspin-Resonanzsignalen. An ihrer Stelle kann aber auch eine gesonderte Hochfrequenz-Empfangsspule verwendet werden.

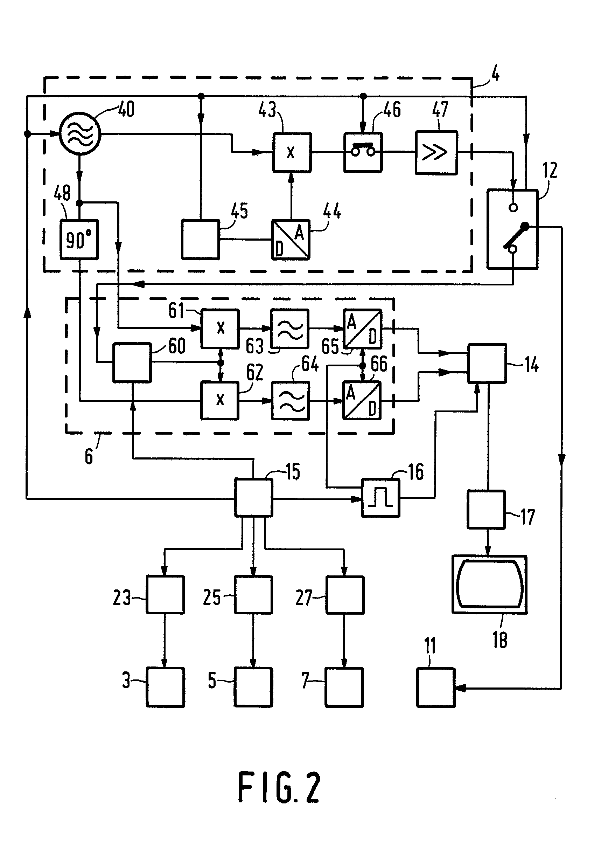

Fig. 2 zeigt ein vereinfachtes Blockschaltbild dieses Kernspin-Tomographiegerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmor frequenz der anzuregenden Atomkerne bei der von den Spulen 1 erzeugten Feldstärke aufweist. Die Larmorfrequenz f berechnet sich bekanntlich nach der Beziehung $f = cB$, wobei B die magnetische Induktion in dem stationären homogenen Magnetfeld darstellt und c das gyromagnetische Verhältnis, das beipielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird - gesteuert durch eine Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das in der Hochfrequenzspule 11 induzierte Kernspin-Resonanzsignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die im Speicher 14 gespeicherten Datenworte bzw. Abtastwerte werden einem Rechner 17 zugeführt, der daraus die räumliche Verteilung der Kernmagnetisierung in einer Schicht des Untersuchungsbereiches ermittel und die ermittelte Verteilung an einer geeigneten Wiedergabeeinheit, z.B. einem Monitor 18, ausgibt. - Die drei Spulenanordnungen 3, 5 und 7 werden von Stromgeneratoren 23, 25 und 27 jeweils mit einem Strom versorgt, dessen zeitlicher Verlauf durch die Steuereinheit 15 steuerbar ist.

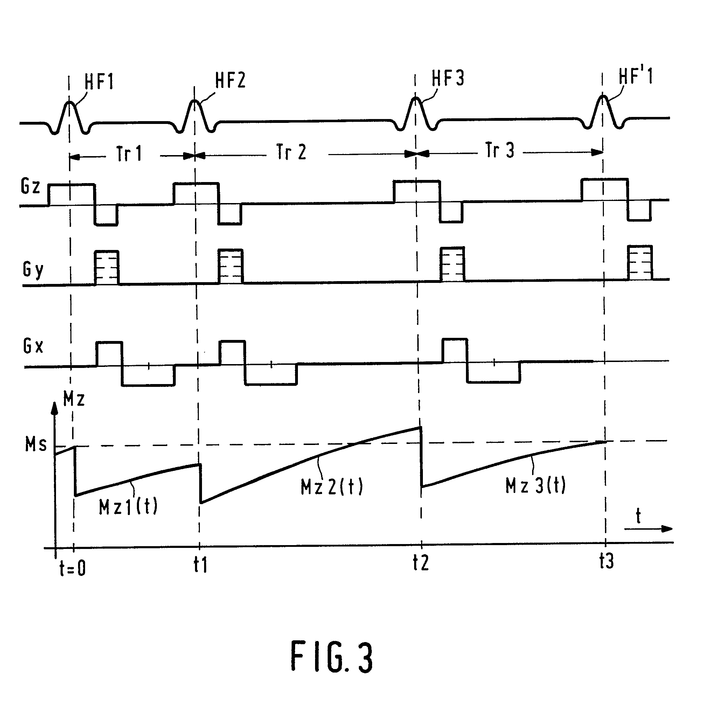

In Fig. 3 ist der zeitliche Verlauf der von der Hochfrequenzspule 11 und den Gradientenspule 3, 5 und 7 erzeugten Signale sowie der zeitliche Verlauf der Längsmagnetisierung in einem Bildpunkt für eine aus drei Teilsequenzen bestehende Sequenz dargestellt.

Die erste Zeile zeigt die zeitliche Lage der Hochfrequenzimpulse. Zur Zeit t=0 wird die Hochfrequenz HF1 der ersten Teilsequenz ausgestrahlt. Um die Repetitionszeit Tr1 später, d.h. zur Zeit t=t1, folgt der Hochfrequenzimpuls HF2 der zweiten Teilsequenz. Nach Verstreichen der Repetitionszeit Tr2, d.h. zur Zeit t=t2, folgt der Hochfrequenzimpuls HF3 der dritten Teilsequenz. Nach der Repetitionszeit Tr3, d.h. zur Zeit t=t3, folgt schließlich der Hochfrequenzimpuls HF'1 der zur ersten Teilsequenz der nächsten Sequenz gehört. Die nächste Sequenz - und alle folgenden Sequenzen - besteht wiederum aus drei Teilsequenzen mit den Repetitionszeiten Tr1, Tr2 und Tr3. Die Hochfrequenzimpulse haben allen einen identischen zeitlichen Verlauf, so daß sie die Kernmagnetisierung jeweils um den gleichen Winkel aus der Längsrichtung kippen können. Der zeitliche Verlauf und die Leistung der Hochfrequenzimpulse sind dabei so gewählt, daß dieser Winkel größer als 0° und kleiner als 90° ist. Die Repetitionszeiten Tr1, Tr2 und Tr3 weichen jedoch voneinander ab.

Die Steuereinrichtung 15 steuert den Stromgenerator 23 so, daß die Gradientenspule 3 während jedes der genannten Hochfruenzimpulse ein magnetisches Gradientenfeld Gz erzeugt. Nach dem Verschwinden des Hochfrequenzimpulses wird, wie die zweite Zeile von Fig. 3 zeigt, die Polarität des magnetischen Gradientenfeldes Gz umgeschaltet und danach abgeschaltet derart, daß das zeitliche Integral über dieses magnetische Gradientenfeld von der Mitte des Hochfrequenzimpulses bis zum Abschalten gerade den Wert Null hat. Dadurch wird erreicht, daß die Hochfrequenzimpulse die Kernmagnetisierung jeweils in derselben Schicht des Untersuchungsbereiches anregen.

Die Steuereinrichtung 15 steuert den Stromgenerator 25 jeweils so, daß unmittelbar nach jedem Hochfrequentimpuls ein magnetisches Gradientenfeld Gy erzeugt und danach wieder abgeschaltet wird (dritte Zeile von Fig. 3). Die Steuerung erfolgt derart, daß das zeitliche Integral über das magnetische Gradientenfeld nach einem Hochfrequenzimpuls für alle Teilsequenzen einer Sequenz den gleichen Wert hat. Von Sequenz zu Sequenz wird dieser Wert jedoch geändert.

Weiterhin steuert die Steuereinrichtung den Stromgenerator 27 so, daß die Gradientenspulen 7 nach jedem Hochfrequenzimpuls ein magnetisches Gradientenfeld Gx (vgl. vierte Zeile von Fig. 3) einschalten, um danach die Polarität umzuschalten und das Feld abzuschalten, wenn das zeitliche Integral über Gx einen Wert erreicht hat, der entgegengesetzt gleich dem Wert unmittelbar vor dem Umschalten dieses Feldes ist. In dem Zeitintervall zwischen dem Umschalten und dem Abschalten des magnetischen Gradientenfeldes Gx gibt die Steuereinrichtung 15 den Taktimpulsgenerator frei, so daß die von der Hochfrequenzspule gelieferten, in den Niederfrequenzbereich transponierten Kernspin-Resonanzsignale - in diesem Fall sogenannte Gradienten-Echos - in eine Folge digitaler Datenworte umgesetzt und in dem Speicher 14 gespeichert werden.

Der zeitliche Verlauf der magnetischen Gradientenfelder Gx, Gy und Gz entspricht dem bei dem zweidimensionalen Fourier-Bildgebungsverfahren üblichen Verlauf. Stattdessen kann aber auch ein anderer zeitlicher Verlauf gewählt werden, beispielsweise entsprechend dem Projektions-Rekonstruktionsverfahren. Wesentlich ist nur, daß die räumliche Verteilung von Frequenz und/oder Phase für die Teilsequenzen, die zu einer Sequenz gehören, gleich ist, sich jedoch von Sequenz zu Sequenz ändert. Es ist auch möglich, die zeitlichen Verläufe der Gradientenfelder Gx, Gy und Gz zu vertauschen, so daß beispielsweise nicht eine zur z-Achse senkrechte Schicht, sondern eine zur y- oder x-Achse senkrechte Schicht entsteht.

Die in Fig. 3 dargestellte und drei Teilsequenzen umfassende Sequenz wird eine Vielzahl von Malen wiederholt, wobei lediglich der Phasenkodierungsgradient Gy von Sequenz zu Sequenz geändert wird. Die dabei im Speicher 14 gespeicherten Abtastwerte der Echosignale werden vom Rechner 17 so zusammengefaßt, daß die Abtastwerte, die in Teilsequenzen mit jeweils der gleichen Repetitionszeit entstanden sind, gemeinsam verarbeitet und daraus in an sich bekannter Weise jeweils ein Tomogramm erzeugt wird, das die räumliche Verteilung der zur Richtung des stationären Magnetfeldes senkrechten Komponente der Kernmagnetisierung beinhaltet.

Die fünfte Zeile der Fig. 3 zeigt den zeitlichen Verlauf der in Richtung des stationären Magnetfeldes verlaufenden Komponente $M_z$ der Kernmagnetisierung, die oft auch als Längsmagnetisierung bezeichnet wird. Wie bereits erwähnt, gehen der eigentlichen Untersuchung so viele Sequenzen voraus, bis ein stationärer Zustand erreicht ist. Trotz dieses stationären Zustandes weichen die Längsmagnetisierungen zu Beginn der verschiedenen Teilsequenzen von einander ab, weil die Repetitionszeiten Tr1, Tr2, Tr3 voneinander abweichen.

Die Längsmagnetisierung hat unmittelbar vor Beginn des Hochfrequenzimpulses HF1 der ersten Teilsequenz den Wert $M_S$. Durch den ersten Hochfrequenzimpuls HF1 wird die Kernmagnetisierung aus der Richtung des stationären magnetischen Feldes, d.h. aus der z-Richtung um den Winkel $\beta$ gekippt. Somit ergibt sich unmittelbar nach dem Hochfrequenzimpuls HF1 in dem betreffenden Bildpunkt eine senkrecht zur z-Achse verlaufende Magnetisierungskomponente Mxy, wobei die Beziehung gilt:

$$Mxy = M_S \sin\beta \quad (1)$$

Der in dem Tomogramm aus den jeweils ersten Teilsequenzen für den betreffenden Bildpunkt bestimmte Wert entspricht diesem Wert Mxy.

Unmittelbar nach dem ersten Hochfrequenzimpuls HF1 verbleibt somit eine Längsmagnetisierung

$$Mz = M_S \cos\beta \quad (2)$$

Diese Längsmagnetisierung relaxiert anschließend in Richtung auf die Ursprungsmagnetisierung $M_o$ ($M_o$ ist der Wert der Längsmagnetisierung, der sich vor Beginn der Hochfrequenzanregung bzw. genügend lange nach Ende der Hochfrequenzanregung einstellt) nach der Beziehung:

$$Mz1(t) = M_S(\cos\beta + (M_o/M_S - \cos\beta)(1-e^{-t/T1})) \quad (3)$$

Der zeitliche Verlauf von Mz1(t) ist aus Fig. 3 ersichtlich. Unmittelbar vor Auftreten des Hochfrequenzimpulses HF2, d.h. ungefähr zur Zeit t=t1, hat die Längs magnetisierung den Wert M2, so daß die Beziehung gilt:

$$M2 = Mz1(t=Tr1) \quad (4)$$

Nach dem Hochfrequenzimpuls HF2 ergibt sich dann die Quermagnetisierung

$$Mxy = M2 \sin\beta \quad (5)$$

und die Längsmagnetisierung

$$Mz = M2 \cos\beta \quad (6)$$

Die Längsmagnetisierung relaxiert anschließend wiederum gegen den Wert $M_o$ mit einer der Längsrelaxationszeit T1 entsprechenden Zeitkonstante, so daß die Beziehung gilt:

$$Mz2(t) = M2(\cos\beta + (M_o/M2 - \cos\beta)(1-e^{-t/T1})) \quad (7)$$

t hat beim Auftreten des zweiten Hochfrequenzimpulses HF2 den Wert Null. Der Verlauf vom Mz2(t) ist ebenfalls aus der letzten Zeile von Fig. 3 ersichtlich.

Nach Ablauf der Repetitionszeit Tr2 hat die Längsmagnetisierung den Wert M3 erreicht, so daß gilt:

$$M3 = Mz2(t=Tr2) \quad (8)$$

Die nach dem dritten Hochfrequenzimpuls HF3 auftretende Quermagnetisierung Mxy berechnet sich zu:

$$Mxy = M3 \sin\beta \quad (9),$$

während für die verbleibende Längsmagnetisierung wiederum gilt:

$$Mz = M3 \cos\beta \quad (10).$$

Die Längsmagnetisierung relaxiert wiederum gegen die Ursprungsmagnetisierung $M_o$, nach der Beziehung:

$$Mz3(t) = M3(\cos\beta + (M_o/M3 - \cos\beta)(1-e^{-t/T1})) \quad (11),$$

wobei t den zeitlichen Abstand vom dritten Hochfrequenzimpuls HF3 bezeichnet.

Nach der Repetitionszeit Tr3 hat die Kernmagnetisierung Mz3(t) dann den Wert Ms erreicht. Es gilt also:

$$M_S = Mz3(t=Tr3) \quad (12)$$

Danach beginnt die nächste Sequenz, deren erster Hochfrequenzimpuls mit HF'1 bezeichnet ist. Die Werte $M_S$, M2 und M3 der Längsmagnetisierung ergeben sich aus den drei Tomogrammen, weil die in diesen Tomogrammen für einen Bildpunkt bestimmten Werte Mxy gemäß den Gleichungen (1), (5) und (9) den Werten Ms, M2 bzw. M3 proportional sind. Da darüber hinaus M2, M3 und $M_S$ gleich dem Wert Mz1(t), Mz2(t), Mz3(t) zur Zeit t=Tr1, t=Tr2 bzw. t=Tr3 sind, gibt es in den drei Gleichungen (3), (7) und (11) nur die Unbekannten $\beta$, $M_o$ und t1, so daß damit t1 bestimmt werden kann.

Falls der Flipwinkel ß der Hochfrequenzimpulse HF1, HF2 usw. bekannt ist, sind nur zwei Teilsequenzen erforderlich, was zwei Gleichungen mit zwei Unbekannten ergibt.

Die Gleichungen können gegebenenfalls iterativ gelöst werden. Es ist nicht erforderlich, daß diese Lösung für jede Untersuchung und jeden Bildpunkt jedesmal neu berechnet werden muß. Da die zwei bzw. drei Werte der Kernmagnetisierung den Wert T1 nämlich eindeutig festlegen, genügt es, diese Lösungen einmal zu berechnen und in einem Speicher derart zu speichern, daß bei Vorgabe der in den zwei bzw. drei Tomogrammen für einen Bildpunkt ermittelten Werte gemäß den Gleichungen (1), (5) und (9) die zugehörige Lösung für T1 aufgerufen wird.

Bei den Gleichungen (1) bis (12) wurde vorstehend vorausgesetzt, daß die Längsmagnetisierung beim Auftreten des Echosignals den gleichen Wert hat wie beim Auftreten des Hochfrequenzimpulses. Diese Voraussetzung ist zumindest annähernd erfüllt, wenn der zeitliche Abstand zwischen den zur Erzeugung der Tomogramme herangezogenen Gradienten-Echosignalen und den voraufgehenden Hochfrequenzimpulsen klein im Vergleich zur Längsrelaxationszeit ist. Wenn darüber hinaus dieser zeitliche Abstand bei allen Teilsequenzen gleich ist, erfährt die Kernmagnetisierung bis zum Echosignal jeweils die gleiche Querrelaxation, so daß Querrelaxationseffekte bzw. die Querrelaxationszeit T2 keinen Einfluß auf die Bestimmung der Längsrelaxationszeit T1 haben.

In der medizinischen Diagnostik ist neben der Kenntnis der Längsrelaxationszeit T1 meist auch die Kenntnis der Querrelaxationszeit T2 erforderlich. Zur zusätzlichen Bestimmung T2 werden zumindest in jeweils einer der Teilsequenzen, vorzugsweise aber in allen Teilsequenzen, nach dem Hochfrequenzimpuls (HF1 bzw. HF2 usw.) zwei 180°-Impulse oder eine gerade Anzahl von 180°-Impulsen erzeugt, was die Bestimmung der Querrelaxationszeit gestattet, wie aus dem von Philips Medical Systems herausgegebenen Buch "Prinzipien der MR-Tomographie" Seite 22 bzw. Seite 29 an sich bekannt. Durch den ersten 180°-Impuls wird ein Spin-Echo-Signal erzeugt, das mittels eines geeigneten Lesegradienten Gx (vgl. zweite Zeile Fig. 4) erfaßt werden kann. Der 180°-Impuls hat dabei von dem voraufgehenden Hochfrequenzimpuls HF1 der Teilsequenz und dem erzeugten Spin-Echo-Signal jeweils den gleichen Abstand. Der nach dem Auftreten des ersten Spin-Echo-Signals erzeugte zweite 180°-Impuls liefert ein zweites Spin-Echo-Signal mit einer solchen zeitlichen Lage, daß der zweite 180°-Impuls genau in der Mitte zwischen den beiden Spin-Echo-Signalen liegt.

Die ersten und die zweiten Spin-Echo-Signale aller Teilsequenzen mit 180°-Impulsen werden zur Erzeugung je eines Tomogrammes herangezogen. Aus den unterschiedlichen Werten der sich daraus für einen Bildpunkt ergebenden Kernmagnetisierung läßt sich die Querrelaxations-Zeitkonstante T2 bestimmen, wie anhand von Fig. 5 erläutert, die die Quermagnetisierung Mxy als Funktion der Echozeit Te für den gleichen Bildwert zeigt; die Echozeit ist der zeitliche Abstand zwischen dem ersten Hochfrequenzimpuls (z.B. HF1) und dem jeweiligen Spin-Echo-Signal. Te1 und Te2 sollen dabei die Echozeiten sein, die sich für die jeweils erste Teilsequenz ergeben. Wenn der zeitliche Abstand der 180°-Impulse in den beiden anderen Teilsequenzen anders gewählt wird (und aus den daraus erzeugten Spin-Echo-Signalen ebenfalls Tomogramme erstellt werden) ergeben sich, wie durch Kreuze angedeutet, vier weitere Meßpunkte. Da die Abnahme der Quermagnetisierung als Funktion der Zeit ausschließlich durch die Querrelaxationszeit bestimmt wird, läßt sich daraus in einfacher Weise durch exponentielle Anpassung die Querrelaxationszeit T2 bestimmen.

Aufgrund der Verwendung der 180°-Impulse ergibt sich der in der dritten Zeile von Fig. 4 dargestellte zeitliche Verlauf der Längsmagnetisierung, deren Polarität jeweils nach einem 180°-Impuls invertiert wird. Da die Zeitpunkte, zu denen diese Invertierung erfolgt, bekannt sind, läßt sich auch daraus die Längsrelaxationszeit in analoger Weise bestimmen wie in Verbindung mit Fig. 3 erläutert.

Obwohl bei dem erfindungsgemäßen Verfahren jede Sequenz aus zwei bzw. drei Teilsequenzen besteht, ist die Meßzeit zur Erfassung der für ein hochaufgelöstes Tomogramm erforderlichen Echosignale relativ kurz, weil die Dauer einer Teilsequenz im Bereich von 30 ms bis 100 ms liegt.

**Patentansprüche**

1. Verfahren für die Kernspintomographie, wobei in Anwesenheit eines homogenen stationären Magnetfeldes eine Vielzahl von Sequenzen auf einen Untersuchungsbereich einwirkt, die die Erzeugung eines Hochfrequenzimpulses zum Kippen der Kernmagnetisierung um einen Winkel, der kleiner ist als 90°, das Einschalten von magnetischen Gradientenfeldern mit nach Größe oder Richtung von Sequenz zu Sequenz veränderbarem Gradienten und die Erfassung von Kernspin-Resonanzsignalen während oder nach der Einwirkung der magnetischen Gradientenfelder einschließen,
dadurch gekennzeichnet, daß jede Sequenz aus wenigstens zwei aufeinanderfolgenden Teilsequenzen besteht, die einen Hochfrequenzimpuls (HF1, HF2, HF3) umfassen und sich durch die Repetitionszeit (Tr1, Tr2, Tr3) unterscheiden, daß aus den Echosignalen der Teilsequenzen mit jeweils gleicher Repetitionszeit je ein Tomogramm berechnet wird, und daß aus den unterschiedlichen Werten der Kernmagnetisierung (Mxy) für jeweils den gleichen Bildpunkt in den Tomogrammen und dem zugeordneten Wert der Repetitionszeit (z.B. Tr1) die Längsrelaxationszeit (T1) bestimmt wird.

2. Verfahren nach Anspruch 1,
dadurch gekennzeichnet, daß wenigstens eine der Teilsequenzen zwei 180°-Impulse aufweist, daß aus den davon hervorgerufenen Spin-Echo-Signalen weitere Tomogramme berechnet werden, und daß aus den unterschiedlichen Werten der Kernmagnetisierung dieser Tomogramme und dem Abstand der Spin-Echo-Signale von dem ersten Hochfrequenzimpuls (z.B. HF1) der Teilsequenz die Querrelaxationszeit (T2) bestimmt wird.

3. Verfahren nach Anspruch 2,
dadurch gekennzeichnet, daß wenigstens zwei der Teilsequenzen zumindest zwei 180°-Impulse aufweisen, und daß der Abstand der beiden Impulse von dem ersten Hochfrequenzimpuls in den Teilsequenzen voneinander abweicht.

4. Anordnung zur Durchführung des Verfahrens nach Anspruch 1, mit Mitteln zum Erzeugen eines homogenen stationären Magnetfeldes, Mitteln zum Erzeugen von Hochfrequenzimpulsen, Mitteln zum Erzeugen wenigstens eines magnetischen Gradientenfeldes mit von Sequenz zu Sequenz veränderbarer Größe oder Richtung des Gradienten, einer Steuereinheit zum Steuern der Mittel zur Erzeugung der Hochfrequenzimpulse und Mittel zum Erzeugen des magnetischen Gradientenfeldes, Mitteln zum Erfassen von Kernspin-Resonanzsignalen und einer Recheneinheit zur Erzeugung von Tomogrammen aus den Kernspin-Resonanzsignalen,

dadurch gekennzeichnet, daß die Steuereinheit so ausgebildet ist, daß jeweils zwei hinsichtlich der Repetitionszeit voneinander abweichende Teilsequenzen aufeinanderfolgen, und daß die Recheneinheit so programmiert ist, daß aus den Echosignalen von Teilsequenzen mit jeweils gleicher Repetitionszeit je ein Tomogramm berechnet wird, daß aus den in den Tomogrammen enthaltenen Werten der Kernmagnetisierung für jeweils einen Bildpunkt und aus der zugehörigen Repetitionszeit die Längsrelaxationszeit für den jeweiligen Bildpunkt bestimmt wird.

0276034

FIG.1

FIG.4

FIG.5

# FIG.2

0276034

FIG.3